# EUROPÄISCHE PATENTSCHRIFT

(11) **EP 2 530 841 B1**
(45) Veröffentlichungstag und Bekanntmachung des Hinweises auf die Patenterteilung: **29.05.2019**
(21) Anmeldenummer: 12165346.3
(22) Anmeldetag: 24.04.2012
(51) Int. Cl.: H03H 21/00, H02H 3/33, H02H 3/34, H02H 9/02, H02H 3/16, H03H 7/01, H03H 7/42

(54) **Vorrichtung und Verfahren zum Schutz eines Netzfilters**
Device and method for protecting a mains filter
Dispositif et méthode pour protéger un filtre réseau

(30) Priorität: 01.06.2011 DE 102011076877
(43) Veröffentlichungstag der Anmeldung: 05.12.2012
(73) Patentinhaber: Siemens Healthcare GmbH, 91052 Erlangen (DE)
(72) Erfinder: Graßl, Tobias, 91056 Erlangen (DE); Beyerlein, Walter, 91088 Bubenreuth (DE); Weidinger, Thomas, 91052 Erlangen (DE); Gebhardt, Andre, 91459 Markt Erlbach (DE)

(56) Entgegenhaltungen:
- EP-A1- 1 456 728
- GB-A- 923 292
- US-A- 4 544 899
- US-A1- 2002 070 821
- US-A1- 2002 105 765
- US-A1- 2010 182 100

## Beschreibung

Die Erfindung betrifft eine Vorrichtung gemäß Anspruch 1, und ein Verfahren gemäß Anspruch 8.

Netzfilter sind elektronische Komponenten zur Reduktion von Störaussendungen, die unter anderem durch Erdableitströme verursacht werden.

Unter Erdableitströmen werden unerwünschte Ströme verstanden, die aus einem fehlerfreien Leistungsstromkreis zum Beispiel über eine Erdkapazität, wie sie beispielsweise ein leitfähiges Teil wie ein geerdeter Kühlkörper oder ein mit Erdpotential geschirmtes Kabel darstellt, zur Erde fließen. Ursache für Erdableitströme können beispielsweise leistungselektronische Energiewandler sein, die durch Schaltvorgänge hochfrequente Schalttransiente in den Leistungsstromkreis einspeisen. Der Erdstromkreis schließt sich gewöhnlich dadurch, dass eine andere elektrische Komponente im Leistungsstromkreis den Erdableitstrom wieder aufnimmt und zur Störquelle im Leistungsstromkreis zurückführt.

Erdableitströme können so energiereich werden, dass sie die Erdableitstrom aufnehmende elektrische Komponente in ihrer Funktion stören oder gar beschädigen. Darüber hinaus wirken die elektrischen Leitungen zwischen dieser elektrischen Komponente und der Störquelle wie eine Antenne und strahlen aufgrund der Erdableitströme Störemissionen ab, die wiederum andere elektrische Komponenten in der Umgebung des Erdstromkreises in ihrer Funktion stören. Ebenso stellen zu hohe Erdableitströme eine Gefährdung für Personen dar, da diese Ströme auch über den menschlichen Körper bei Berührung leitender Teile abfließen können. Daher muss eine allzu große Ausdehnung des Erdstromkreises unterbunden werden.

Dies geschieht herkömmlich über die eingangs genannten Netzfilter, die den Eingang der Störquelle mit Entstörkondensatoren für Erdableitströme der Erde kurzschließen und so den Erdstromkreis nicht auf andere elektrische Komponenten im Leistungsstromkreis ausdehnen lassen. Aufgrund der begrenzten Wirkung der Entstörkondensatoren sind zudem Drosseln notwendig, um die nicht über die Entstörkondensatoren rückführbaren Erdableitströme am Eingang der Störquelle zu dämpfen. Da diese nicht erdungsfähigen Erdableitströme immer noch sehr energiereich sein können, müssen die Drosseln hohe Induktivitätswerte besitzen, was sie teuer macht und in einer Vorrichtung zur Erhöhung der elektromagnetischen Verträglichkeit viel Platz in Anspruch nimmt.

Aus der US 4 544 899 A ist ein Netzfilter mit einer zwischen einer Energiequelle und einer Last geschalteten Filterschaltung bekannt. Eine mit der Filterschaltung gekoppelte Regeleinrichtung erfasst die Eigenschaften einer Versorgungsspannung der Energiequelle. Die Regeleinrichtung steuert die Filterschaltung in Abhängigkeit der erfassten Eigenschaften derart an, dass die Eigenschaften der Filterschaltung an die Versorgungsspannung angepasst werden.

Die US 2002/0070821 A1 beschreibt einen Netzfilter, welcher einen mit einem Umrichter verbundenen Funkstörungsfilter aufweist. Der Funkstörungsfilter weist Kondensatoren zur Ableitung eines Störsignals auf dem ein Widerstand in Reihe geschaltet ist. Parallel zu dem Kondensator und dem Widerstand ist ein Schalter vorgesehen, welcher mittels eines Steuersignals einer Steuereinrichtung geöffnet und geschlossen werden kann.

In der US 2010/0182100 A1 ist ein Netzfilter zur Filterung einer Rauschkomponente in einer Stromleitung offenbart. Der bekannte Netzfilter weist eine Drossel und ein Nebenschlussmodul auf. Das Nebenschlussmodul weist einen Hochpassfilter auf, welcher ein der Rauschkomponente entsprechendes Rauschsignal erzeugt. Das erzeugte Rauschsignal wird zur Ansteuerung einer Quelle genutzt, welche einen durch das Rauschsignal kontrollierten elektrischen Strom gegen eine Erde nebenschliesst.

Die WO 03/044612 A1 betrifft ein Schaltungsbauteil mit einer steuerbaren Impedanz. Das Schaltungsbauteil weist einen Körper aus einem magnetisierbaren Material auf, um welchen zwei senkrecht zueinander verlaufende Wicklungen gewickelt sind. Die erste Wicklung ist mit einem Netzwerk gekoppelt, wobei die zweite Wicklung mit einer Steuereinheit zur Steuerung der Impedanz in dem Netzwerk gekoppelt ist.

Die US 2002/0105765 A1 beschreibt ein Netzwerk für einen Photovoltaikgenerator, bei welchem ein Energiewandler die Gleichspannung einer Solarbatterie in eine Wechselspannung wandelt. Zur Erfassung eines Erdungsfehlers wird der Strom der Solarbatterie bestimmt und von einem bewirkten Erdableitungsstrom bereinigt. Der bereinigte Stromwert wird mit einem vorgegebenen Schwellwert als Maß für einen Erdungsfehler verglichen.

Die GB 923 292 A offenbart eine Vorrichtung zur Erfassung von Erdungsfehlern in einem elektrischen Versorgungssystem. Die Vorrichtung umfasst einen Drosselkern, welcher die Leitungen eines Netzwerks einfasst und mit einer Wicklung bewickelt ist, welche an eine Sekundärseite eines Transformators geführt ist. Die Vorrichtung weist ein Filter auf, der an die Primärseite des Transformators geführt ist.

Es ist daher Aufgabe der Erfindung in einer Vorrichtung zur Reduzierung hochfrequenter Ableitströme, erzeugt durch eine Störquelle, Platz zu sparen und die Kosten zu reduzieren.

Die Aufgabe wird durch die Merkmale der unabhängigen Ansprüche gelöst. Die abhängigen Ansprüche enthalten bevorzugte Weiterbildungen der Erfindung.

Der Erfindung geht von der Erkenntnis aus, dass in einem geerdeten Leistungsstromkreis keine Nutzströme über die Erdung fließen wenn der Leistungsstromkreis fehlerfrei arbeitet. Diese Erkenntnis basiert auf dem Gedanken, dass ein Leistungsstromkreis zur elektrischen Energieversorgung nicht über eine Erdung geschlossen werden darf, da sonst bestimmte Sicherungsvorrichtungen wie beispielsweise ein Fehlerstromschutzschalter nicht funktionieren. In der Praxis fließen die von der elektrischen Energiequelle abgegebenen Ströme zur Versorgung eines elektrischen Verbrauchers zwischen den Phasen. Optional fließen die Ströme auch über einen Nullleiter ab. Eine weitere Erkenntnis der Erfindung ist, dass aus diesem Grund ein eingangs genannter Netzfilter zur Reduktion von störenden Transienten in Form von Erdableitströmen prinzipiell auch den Frequenzbereich der Leistungsströme abdecken darf und somit über den gesamten verfügbaren Frequenzbereich ausgelegt werden kann. Im Fehlerfall, wenn beispielsweise eine Phase ausfällt, könnten die Leistungsströme statt über die Phase, die jedoch ausgefallen ist, über den Netzfilter und die Erde zur elektrischen Energiequelle zurückgeführt werden, wodurch die Ableitströme zu groß werden und eventuell der Netzfilter zu hoch belastet werden kann. Die Erfindung schlägt daher vor, den Netzfilter in derartigen Fehlerfällen so zu verändern, dass die Leistungsströme nicht über den Netzfilter abgeleitet werden können. Im einfachsten Fall kann dazu die störenden Transiente ableitende Kapazität soweit verringert werden, dass durch die erhöhte Impedanz die Erdableitströme im Frequenzbereich der Leistungsströme reduziert werden.

Die Erfindung gibt daher eine Vorrichtung zur Verbesserung der Filterwirkung zwischen einer elektrischen Energiequelle und einer Störquelle verschalteten Filters an, der ausgebildet ist, Störtransiente aus der Erde in den Eingang der die Störtransiente erzeugenden Störquelle zurückzuführen. Die Vorrichtung umfasst eine Messeinrichtung zum Erfassen eines durch den Filter fließenden Fehlerstromes und eine Stelleinrichtung, die ausgebildet ist, eine Grenzfrequenz des Filters derart zu verändern, dass der Fehlerstrom durch den Filter unter ein vorbestimmtes Pegel gedämpft wird, wenn die Messeinrichtung den Fehlerstrom erfasst. Durch die Stelleinrichtung kann das Filter situationsgerecht an einen Fehlerfall angepasst werden, so dass verschiedene Filterkomponenten des Filters, die die Funktion des Filters im Fehlerfall und im Normalbetrieb sicherstellen zusammengefasst werden können. Dies spart nicht nur Platz sondern senkt auch die Kosten des Filters. Beim Fehlerstrom handelt es sich dabei um einen im Filter fehlgeleiteten Leistungsstrom aus der elektrischen Energiequelle, der von einem für den Leistungsstrom vorgesehenen Strompfad abweicht, wobei der vorgesehene Strompfad durch das Filter und die Störquelle geführt ist.

Das Filter weist wenigstens eine Kapazität auf und die Stelleinrichtung ist zum Verändern der Grenzfrequenz des Filters ausgebildet, die Kapazität zu erhöhen. Diese ermöglicht es, Kapazitäten im Filter über einen breiteren Frequenzbereich zum Filtern der störenden Transiente auszulegen. So kann der Filter mit nieder-induktiveren Drosseln ausgestattet werden, wodurch der Netzfilter nicht nur preiswerter realisierbar ist sondern auch kompakter aufgebaut werden kann. Bleibt die Erhöhung begrenzt, kann der Filter selbst im Fehlerfall weiterverwendet werden, so dass die Leistungsversorgung zu einem Verbraucher nicht unterbrochen werden muss. Dies stellt einen vorteilhaften Unterschied zu anderen Netzschutzmechanismen, wie eine beispielsweise eine Sicherung oder einen Fehlerstromschutzschalter dar, die im Regelfall die elektrische Energieversorgung vollständig unterbrechen.

In einer bevorzugten Weiterbildung kann die elektrische Energiequelle zur mehrphasigen elektrischen Energieabgabe an die Störquelle und das Filter zum Zurückführen von Störtransienten aus der Erde in den Eingang der Störquelle in allen Phasen inklusive Nullleiter vorgesehen sein, wobei die Messeinrichtung zum Erfassen des Fehlerstromes ausgebildet sein kann, eine unsymmetrische elektrische Energieabgabe aus der elektrischen Energiequelle zu erfassen. Da im Falle einer Unsymmetrie der elektrischen Energiequelle ein sehr hoher Erdableitstrom fließen kann, der im schlimmsten Falle, der Ausfall einer Phase der elektrischen Energiequelle ist, kann durch die Erfindung der Ableitstrom wirkungsvoll reduziert werden. Herkömmliche Netzfilter bräuchten zur Reduktion der Ableitströme für einen vergleichbaren Fall Drosseln, insbesondere Gleichtaktdrosseln mit einer hohen Induktivität, die mit speziellen Wicklungsverfahren hergestellt werden müssen, um die Gegeninduktivität nicht unnötig zu erhöhen. Derartige Drosseln sind sehr teuer, auf die durch den Einsatz der angegebenen Vorrichtung verzichtet werden kann.

In einer besonders bevorzugten Weiterbildung kann die Messeinrichtung zum Erfassen der unsymmetrischen elektrischen Energieabgabe basierend auf den Phasenströmen der elektrischen Energiequelle und/oder den Phasenspannungen der elektrischen Energiequelle und/oder den Gleichtaktstörungen in den einzelnen Phasen zwischen der der elektrischen Energiequelle (6, 54, 80) und der Störquelle und/oder einem Spannungsabfall von einem künstlichen Sternpunkt im Filter zur Erde vorgesehen sein. Diese Methoden sind mit bekannten Messgeräten auf einfache Weise kostengünstig realisierbar. Darüber hinaus können für die Ermittlung der Abweichung verschiedene Messprinzipien bereitgestellt werden, die zur Erhöhung der Zuverlässigkeit gegeneinander verglichen werden können.

Das Filter ist zum Weiterleiten einer elektrischen Energie aus einer elektrischen Energiequelle an eine Störquelle und zum Zurückführen von Störtransienten aus der Erde in den Eingang der die Störtransiente erzeugenden Störquelle ausgebildet. Das Filter umfasst eine angegebene Vorrichtung.

In einer bevorzugten Weiterbildung kann das Filter eine erste Kapazität und eine zweite Kapazität, die parallel zur ersten Kapazität geschaltet ist, umfassen. Dabei ist die erste Kapazität ausgebildet, Störtransiente mit der Frequenz des Fehlerstromes und die zweite Kapazität ausgebildet, Störtransiente mit einer von der Frequenz des Fehlerstromes verschiedenen Frequenz zu leiten. Auf diese Weise kann die zweite Kapazität in herkömmlicher Weise zur Filterung von Erdableitströmen dimensioniert werden, während die erste Kapazität auch dahingehend dimensioniert werden kann einen möglichst hohen Strom zu leiten. Auf diese Weise kann die Grenzfrequenz des Filters durch Verändern der ersten Kapazität näher an die Frequenz der elektrischen Energiequelle herangeführt werden.

In einer bevorzugten Weiterbildung kann die Stelleinrichtung ausgebildet sein, die erste Kapazität vom Filter elektrisch zu trennen, wenn die Messeinrichtung den Fehlerstrom erfasst. Auf diese Weise kann eine begrenzte Anzahl an vorbestimmten Verschaltungen eingeführt werden, die die angegebene Vorrichtung im Filter bei Bedarf schnell auswählen und einstellen kann, so dass eine schnellstmögliche Reaktion im Fehlerfall gesichert ist.

Ein Netzwerk zur elektrischen Energieversorgung eines elektrischen Verbrauchers aus einer elektrischen Energiequelle umfasst den elektrischen Verbraucher; einen elektrischen Wandler zum Wandeln einer Netzspannung aus dem Netzwerk in eine Lastspannung für den elektrischen Verbraucher und einen angegebenen Filter, wobei der elektrische Wandler die Störquelle ist.

In einer Ausführung der Erfindung kann die vorbestimmte Frequenz die Frequenz einer elektrischen Energiequelle sein, an die die Störquelle angeschlossen ist. Auf diese Weise wird die Kapazität vor einer Überlast geschützt. Der durch die Vorrichtung geschützte Filter ist dadurch nicht nur ausfallsicherer sondern auch langlebiger, da er wirkungsvoll vor Strömen geschützt werden kann, die seine Lebensdauer reduzieren können.

Der elektrische Wandler ist ein Gleichrichter. In einem aktiven Modus kann der Gleichrichter zur Leistungsfaktorkorrektur im Netzwerk verwendet werden.

In der Erfindung ist die Stelleinrichtung im Falle der unsymmetrischen elektrischen Leistungsabgabe zum Überführen des elektrischen Wandlers in einen passiven Betriebsmodus vorgesehen sein, so dass vermieden wird, dass die durch die Störquelle erzeugten Erdableitströme, die durch das Verändern der Kapazität im Filter weniger effektiv filterbar sind, reduziert werden.

In einer alternativen Ausführung der Erfindung kann die Stelleinrichtung im Falle einer unsymmetrischen elektrischen Leistungsabgabe zum Reduzieren der Leistungsabgabe des elektrischen Wandlers vorgesehen sein, so dass gesichert ist, dass die durch die Störquelle erzeugten Erdableitströme mit einem geringeren Pegel erzeugt werden.

Die Erfindung gibt auch ein Verfahren zum Schutz eines Filters an, das ausgebildet ist, Störtransiente aus der Erde in den Eingang einer die Störtransiente erzeugenden Störquelle zurückzuführen. Das Verfahren umfasst die Schritte Erfassen eines durch den Filter fließenden Fehlerstromes und Verändern einer Grenzfrequenz des Filters derart, dass der Fehlerstrom durch den Filter unter ein vorbestimmtes Pegel gedämpft wird, wenn der Fehlerstrom erfasst wird.

Weiterbildungen des Verfahrens können Verfahrensschritte sein, die die Merkmale der angegebenen Vorrichtung, des Filters oder des Netzwerkes gemäß den Unteransprüchen sinngemäß realisieren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Darin zeigen:
- FIG 1: ein Netzwerk mit einer herkömmlichen Netzfilterschaltung;
- FIG 2: ein Netzwerk mit einer Netzfilterschaltung, die durch eine Vorrichtung gemäß einem ersten Ausführungsbeispiel der Erfindung gesteuert wird;
- FIG 3: ein Netzwerk mit einer Netzfilterschaltung, die durch eine Vorrichtung gemäß einem nicht beanspruchten Beispiel gesteuert wird;
- FIG 4: ein Netzwerk mit einer Netzfilterschaltung, die durch eine Vorrichtung gemäß einem zweiten Ausführungsbeispiel der Erfindung gesteuert wird und
- FIG 5: verschiedene Topologien für eine durch eine Vorrichtung der Erfindung steuerbare Netzfilterschaltung.

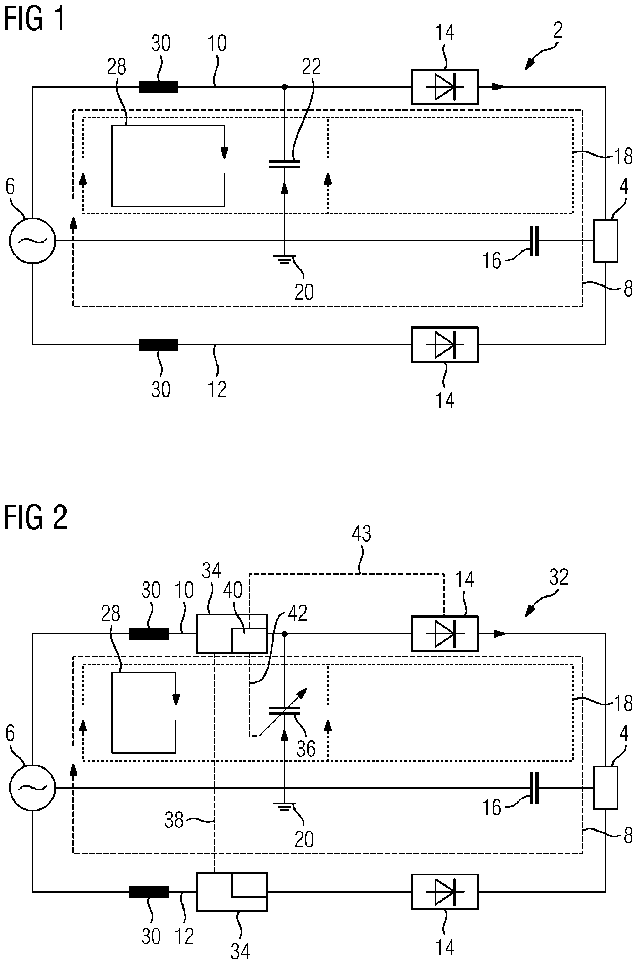

FIG 1 zeigt ein Netzwerk 2, in dem ein elektrischer Verbraucher 4 mit elektrischer Energie aus einer symmetrischen elektrischen Energiequelle 6 über einen Stromkreis mit Leistungsstrom 8 versorgt wird. Der Leistungsstrom 8 fließt durch eine erste Phase 10 und eine zweiten Phase 12, wobei die Leistungsströme 8 der einzelnen Phasen 10, 12 gegeneinander um eine Halbwelle verschoben sind. Das gleiche gilt für die Spannungen der einzelnen Phasen 10, 12. Außer durch die beiden Phasen 10, 12 fließen im Fall einer fehlerfreien elektrischen Energieversorgung des elektrischen Verbrauchers 4 keine weiteren Leistungsströme.

Zur Anpassung der elektrischen Energie aus der elektrischen Energiequelle 6 an die Erfordernisse des elektrischen Verbrauchers 4 ist ein Energiewandler vorgesehen, der in der vorliegenden Ausführung ein Gleichrichter 14 ist. Der Gleichrichter 14 ist in den beiden Phasen 10, 12 angeordnet und kann in einem aktiven Modus, in dem er eine Wechselspannung aus der elektrischen Energiequelle 6 durch Schaltvorgänge gleichrichtet und in einem passiven Modus betrieben werden, in dem er die Wechselspannung mit Dioden gleichrichtet.

Im aktiven Modus des Gleichrichters 14 erzeugen die Schaltvorgänge transiente Störströme, die vom elektrischen Verbraucher 4 über eine Erdkapazität 16 als Erdableitstrom 18 in die Erde 20 geleitet werden. Der Stromkreis des Erdableitstromes 18 wird über einen internen Widerstand in der elektrischen Energiequelle 6 geschlossen. In FIG 1 ist der Übersichtlichkeit halber lediglich der Stromkreis des Erdableitstromes 18 für die erste Phase 10 eingezeichnet. Gleichwohl existiert ein entsprechender Erdableitstromkreis für die zweite Phase 12. Die nachfolgenden Betrachtungen gelten für beide Erdableitstromkreise entsprechend.

Die elektrischen Leiterbahnen zwischen der elektrischen Energiequelle 6 und dem elektrischen Verbraucher 4 wirken wie eine Antenne und strahlen angeregt vom Erdableitstrom 18 Störemissionen in die Umgebung ab, die andere elektrische Geräte in ihrer Funktion stören. Zur Begrenzung dieser Störemissionen muss der Erdableitstrom 18 durch ein Netzfilter begrenzt werden. Ein solches Netzfilter stellt eine Kapazität 22 dar, die den Erdableitstrom 18 unmittelbar in den Eingang des Gleichrichters 14 zurückleitet und so die Leiterbahnen, über die der Erdableitstrom 18 fließen kann, kurz hält. Nachstehend wird die Kapazität 22 daher Netzfilterkapazität 22 bezeichnet. Eine derartige Netzfilterkapazität verbindet auch den Eingang des Gleichrichters 14 in der zweiten Phase 12 mit der Erde 20.

Die Netzfilterkapazität 22 muss so dimensioniert sein, dass sie für alle erdenklichen Frequenzen den Erdableitstrom 18 zurück in den Eingang des Gleichrichters 14 leiten kann. Dazu sollte die Netzfilterkapazität 22 breitbandig und damit so groß wie möglich dimensioniert sein, um auch einen Erdableitstrom 18 mit tiefen Frequenzen wirkungsvoll zu filtern. Diese Dimensionierung ist jedoch durch ein mögliches Fehlverhalten der elektrischen Energiequelle 6 oder des elektrischen Verbrauchers 4 beschränkt, das zu einem Fehlerstrom 28 durch die Netzfilterkapazität 22 führt, der dazu führen kann, dass über Personen bei einer Berührung zu hohe Ströme abgeleitet werden.

Ein Beispiel für ein Fehlverhalten 24 ist eine unsymmetrische Leistungsabgabe der elektrischen Energiequelle 6. Diese ruft Gleichtaktstörungen zwischen den beiden Phasen 10, 12 und der Erde hervor.

Eine Gleichtaktstörung ist ein gleichphasiger Strom oder eine gleichphasige Spannung zwischen den Phasen 10, 12. Eine Gleichtaktstörung ruft keine Potentialdifferenz zwischen den beiden Phasen 10, 12 hervor, sondern lediglich von den einzelnen Phasen 10, 12 zur Erde 20. Ist die Netzfilterkapazität 22 ausgelegt, Ströme im Frequenzbereich des Leistungsstromes 8 zu leiten, führen die durch die unsymmetrische Leistungsabgabe hervorgerufenen Gleichtaktstörungen daher zum Fehlerstrom 28 zwischen den Phasen 10, 12 zu Erde 20. Da die Gleichtaktstörungen im schlimmsten Falle durch den Ausfall einer Phase 10, 12 hervorgerufen werden, kann der Fehlerstrom 28 im Extremfall zu groß werden, dass die Netzfilterkapazität 22 und/oder ihre Zuleitungen beschädigt wird. Kapazitäten, die Gleichtaktstörungen leiten können, indem sie im Netzwerk 2 in einem zur Erde 20 führenden Zweig liegen, werden Y-Kapazitäten bezeichnet.

Das Gegenteil einer Gleichtaktstörung ist ein Gegentaktstörung, die durch einen gegenphasigen Strom oder eine gegenphasige Spannung zwischen den Phasen 10, 12 gekennzeichnet ist. Die Gegenphasigkeit verursacht eine Potentialdifferenz zwischen den Phasen 10, 12. Der durch die elektrische Energiequelle 6 abgegebene Leistungsstrom 8 in FIG 1 schwingt ebenfalls im Gegentakt, da die symmetrisch Leistungsströme 8 in den einzelnen Phasen 10, 12 jeweils um eine Halbwelle verschoben sind. In FIG 1 nicht gezeigte Kapazitäten, die in einem Zweig liegen, der Gegentakte leiten kann, werden X-Kapazitäten genannt.

Kapazitäten, die Gleichtakte und Gegentakte filtern, bezeichnet man als XY-Kapazitäten.

Herkömmlich wird das Auftreten eines Fehlerstromes 28 durch eine Begrenzung der Netzfilterkapazität 22 vermieden. Durch die Begrenzung ist die Netzfilterkapazität 22 im Frequenzbereich des Leistungsstromes 8 hochohmig und damit nicht leitfähig, dadurch ist die Filterwirkung der Y-Kondensatoren aber beschränkt, weshalb zusätzlich zur Verbesserung der Filterwirkung spezielle Drosseln 30 verwendet werden, die einen großen Platzbedarf und hohe Kosten zur Folge haben. Auch müssen die Drosseln 30 ausgelegt sein, einen ausreichend hohen Strom zu führen, da sie im Stromkreis des Leistungsstromes 8 liegen und daher den Leistungsstrom 8 führen müssen, wobei spezielle kostenintensive Wicklungsverfahren für die Drosseln 30 verwendet werden müssen, um zum Erreichen ausreichender Induktivitätswerte eine Erhöhung der Gegeninduktivität zu vermeiden.

Um den Einsatz derartiger teurer Drosseln 30 im Stromkreis des Leistungsstromes 8 zu vermeiden, schlägt die Erfindung vor, die Kapazitätswerte der Netzfilterkapazität 22 anzupassen, wenn ein Fehlerstrom 28 auftritt. Ein Netzwerk 32 mit einem ersten Ausführungsbeispiel dazu ist in FIG 2 gezeigt. In FIG 2 werden zu FIG 1 gleiche Elemente mit gleichen Bezugszeichen versehen und nicht noch einmal beschrieben.

Das Netzwerk 32 weist eine einstellbare Netzfilterkapazität 36 zur Filterung der in FIG 1 beschriebenen Erdableitströmen 18 auf. Wie in FIG 1 werden die nachstehenden Betrachtungen zur einstellbaren Netzfilterkapazität 36 aus Gründen der Übersichtlichkeit lediglich zwischen der ersten Phase 10 und der Erde 20 gezeigt. Eine entsprechende einstellbare Netzfilterkapazität ist letztlich auch zwischen der zweiten Phase 12 und der Erde 20 verschaltet. Im fehlerfreien Zustand des Netzwerkes ist die Netzfilterkapazität 36 derart eingestellt, dass sie Erdableitströme 18 im Frequenzbereich des Leistungsstromes 8 leiten kann.

Im Fehlerfall, wenn ein Fehlerstrom 28 durch die einstellbare Netzfilterkapazität 36 auftritt, wird ihr Wert verringert und ein Fehlerstrom 28 durch die einstellbare Netzfilterkapazität 36 vermieden. Um das Auftreten eines Fehlerstromes 28 festzustellen, sind in den Phasen 10, 12 des Netzwerks 32 jeweils Messvorrichtungen 34 angeordnet. Diese können über eine Datenleitung 38 Informationen miteinander austauschen und den Fehlerstrom 28 auf verschiedene Wege ermitteln.

Eine Möglichkeit ist, sich die symmetrische elektrische Leistungsabgabe zunutze zu machen, und zu überwachen, ob sich die Spannungen oder die Ströme in den einzelnen Phasen 10, 12 gegenüber der Erde zu jedem Zeitpunkt zu Null aufaddieren lassen. Ist dies nicht der Fall, liegt eine Unsymmetrie vor, die zum Fehlerstrom 28 führt, wenn die einstellbare Netzfilterkapazität 36 zum Führen von Erdableitströmen 18 im Frequenzbereich des Leistungsstromes 8 eingestellt ist. Der Vorteil der Überwachung der Spannungen ist, dass die Spannungen auch im Unsymmetriefall weiterhin überwacht werden können, um die Beseitigung des Fehlers festzustellen und die Netzfilterkapazität 36 automatisch an den Normalbetrieb anzupassen.

Aus den überwachten Strömen in den Phasen 10, 12 können indes Gleichtaktstörungen im Netzwerk 32 abgeleitet werden, die alternativ zur Ermittlung des Fehlerstromes herangezogen werden können. Um die Gleichtaktstörungen zu ermitteln, kann die Messvorrichtung 34 auch in Reihe zur einstellbaren Netzfilterkapazität 36 eingebracht sein, um dort eine Gleichtaktstörung direkt zu messen. Weiter alternativ kann die Messvorrichtung 34 in der in FIG 2 gezeigten Weise im Netzwerk 32 verschaltet sein, wobei zur Erfassung der Gleichtaktstörungen ein separater Stromwandler oder eine Hilfswicklung auf den Drosseln 30 vorgesehen sein kann.

Schließlich kann auch die Symmetrie der elektrischen Leistungsabgabe selbst zur Feststellung herangezogen werden, ob ein Fehlerstrom 28 auftritt. Dazu kann ein in FIG 2 nicht gezeigter künstlicher Sternpunkt eingeführt werden, der die beiden Phasen über X-Kapazitäten miteinander verbindet. Der Sternpunkt selbst kann über eine Y-Kapazität geerdet sein. Im fehlerfreien Fall darf an der Y-Kapazität keine Spannung abfallen. Wird dennoch eine gemessen, so handelt es sich entweder um den Fehlerstrom 28 oder um den Erdableitstrom 18. Über eine Tiefpassfilterung kann der Fehlerstrom 28 ermittelt werden.

Erfasst die Messvorrichtung 34 beispielsweise in der ersten Phase 10 einen zu großen Fehlerstrom 28 kann eine Stellvorrichtung 40 in der Messvorrichtung 34 die einstellbare Netzfilterkapazität 36 über ein erstes Stellsignal 42 derart anpassen, dass weder der Fehlerstrom 28 noch Erdableitströme 18 mit Frequenzen im Bereich des Leistungsstromes 8 durch die einstellbare Netzfilterkapazität 36 fließen können.

Im Gegenzug bedeutet dies, dass Erdableitströme 18 mit Frequenzen im Bereich des Leistungsstromes 8 durch die veränderte Netzfilterkapazität 36 nun nicht mehr direkt in den Eingang des Gleichrichters 14 zurückgeführt und dadurch gefiltert werden können bzw. die Filterwirkung für transiente Erdablaufströme 18 abnimmt. Um dennoch eine Abstrahlung von Störemissionen durch die nun über die elektrische Energiequelle 6 fließenden Erdableitströme 18 zu vermeiden, kann die Stellvorrichtung 40 den Gleichrichter 14 über ein zweites Stellsignal 43 in den oben beschriebenen passiven Modus überführen oder abschalten, so dass die Entstehung der Erdableitströme 18 gemindert wird.

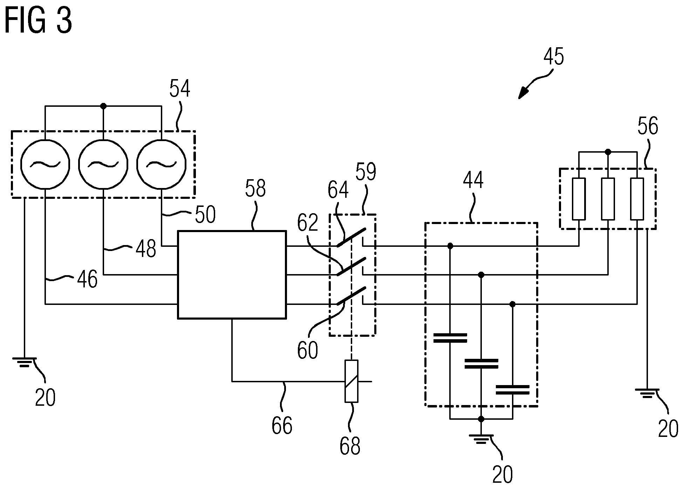

FIG 3 zeigt eine Netzfilterschaltung 44 in einem Netzwerk 45 mit drei Phasen 46, 48, 50. Die Netzfilterschaltung 44 wird durch eine Vorrichtung 58 gemäß einem nicht beanspruchten Beispiel gesteuert. In FIG 3 werden zu den FIG 1 und 2 gleiche Elemente mit gleichen Bezugszeichen versehen und nicht noch einmal beschrieben.

Das Netzwerk 45 wird über eine dreiphasige Energiequelle 54 mit elektrischer Energie versorgt. Die einzelnen Spannungen in der dreiphasigen Energiequelle 54 sind jeweils um 120° verschoben, so dass die vektorielle Summe aller drei Spannungen zu jeder Zeit Null ist. Da sich mit der dreiphasigen Energiequelle 54 in einfacher Weise ein Drehfeld erzeugen lässt, wird der von ihr abgegebene elektrische Strom auch gemeinhin Drehstrom bezeichnet.

Die elektrische Energie wird im Netzwerk 45 zur Versorgung eines dreiphasigen Verbrauchers 56 mit drei verschiedenen Lastwiderständen verwendet, die zwischen den einzelnen Phasen 46, 48, 50 geschaltet sind. Die Widerstände des dreiphasigen Verbrauchers 56 gehören zu einem einzelnen elektrischen Gerät, wie beispielsweise ein Asynchronmotor, der in Sternschaltung betrieben wird. Dabei fließt der Leistungsstrom im fehlerfreien Betrieb lediglich zwischen den Phasen 46, 48, 50. Die Erde 20 bleibt leistungsstromfrei.

Die Netzfilterschaltung 44 schützt das Netzwerk 45 in gleicher Weise vor den Folgen von Erdableitströmen wie die Netzfilterkapazitäten 22, 36 aus den FIG 1 und 2.

Wie in den FIG 1 und 2 kann auch im Netzwerk 45 durch einen Fehler ein Teil des Leistungsstroms über die Netzfilterschaltung 44 abgeleitet und dann über den internen Widerstand in der elektrischen Energiequelle 54 in diese zurückgeführt werden, wenn die Kapazitäten der NetzNetzfilterschaltung 44 ausgelegt sind, Erdableitströme mit Frequenzen im Bereich des Leistungsstromes zu führen. Ein solcher Fehler kann auf einen Ausfall einer der Phasen 46, 48, 50 zurückzuführen sein, bei dem der Stromfluss zur dreiphasigen Last 56 auf der entsprechenden Phase unterbrochen ist.

Um einen Fehlerstrom 28 im Bereich des Leistungsstroms 8 durch die Kapazitäten der Netzfilterschaltung 44 zu vermeiden, ist im Netzwerk 45 eine Messvorrichtung 58 angeordnet, die, wie in FIG 2 die Phasen 46, 48, 50 auf einen Fehler hin überwacht und feststellt, ob die Kapazitäten der Netzfilterschaltung 44 mit Leistungsstrom belastet werden. Die Messvorrichtung 58 ist an ein Netzschütz 59 mit einem Schalter 60, 62, 64 in jeder Phase 46, 48, 50 angeschlossen. Im Fehlerfall, wenn die Kapazitäten der Netzfilterschaltung 44 einen Leistungsstrom führen, spricht die Messvorrichtung 58 über ein Ansteuersignal 66 ein Relais 68 an und unterbricht über die Schalter 60, 62 64 die Phasen 46, 48, 50.

Das Netzwerk 45 kann ebenso in Dreieckschaltung betrieben werden, ohne dass das Funktionsprinzip der Messvorrichtung 58 und des Netzschützes 59 geändert werden müsste.

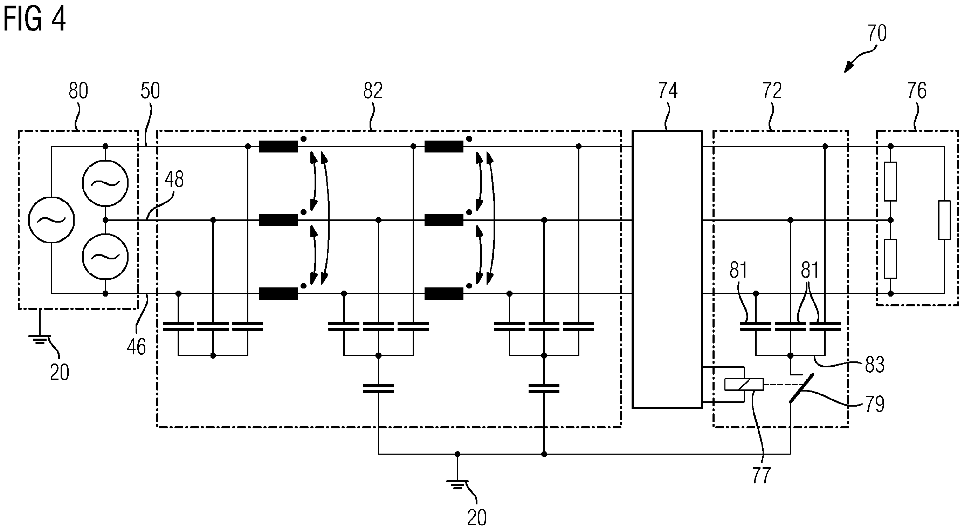

FIG 4 zeigt ein Netzwerk 70 mit einer Netzfilterschaltung 72, die durch eine Messvorrichtung 74 gemäß einem zweiten Ausführungsbeispiel der Erfindung gesteuert wird. In FIG 4 werden zu FIG 1 bis 3 gleiche Elemente mit gleichen Bezugszeichen versehen und nicht noch einmal beschrieben.

Im Netzwerk 70 wird eine Last 76 über die drei Phasen 46, 48, 50 aus einer dreiphasigen elektrischen Energiequelle 80 in Dreieckschaltung mit elektrischer Energie versorgt. Auf den Phasen 46, 48, 50 sind das durch die Messvorrichtung 74 gesteuerte Filter 72 sowie ein ungesteuertes Filter 82 angeordnet, die wie in den vorangegangenen Ausführungsbeispielen Erdableitströme aus der Erde 20 in den Eingang eines nicht gezeigten elektrischen Wandlers zurückleiten können.

Das ungesteuerte Filter 82 weist in FIG 4 nicht näher referenzierte gekoppelte Netzausgleichsdrosseln auf den Phasen 46, 48, 50 und X-Kapazitäten zwischen den Phasen 46, 48, 50 auf, über die Netzunsymmetrien auf den Phasen 46, 48, 50 ausgeglichen werden können. Über Y-Kapazitäten und XY-Kapazitäten können die zuvor erwähnten Erdableitströme in die nicht gezeigte Quelle der Erdableitströme zurückgeführt werden. Die Y- und XY-Kapazitäten des ungesteuerten Filters 82 sind derart dimensioniert, dass sie Erdableitströme im Frequenzbereich des Leistungsstromes aus der elektrischen Energiequelle 80 nur insoweit leiten, dass eine bestimmte Schwellwerte nicht überschritten werden.

Derartige Erdableitströme können durch das gesteuerte Filter 72 gefiltert werden. Das gesteuerte Filter 72 weist einen Schalter 79 sowie drei Kapazitäten 81 auf, über die die drei Phasen 46, 48, 50 zu einer Sternschaltung verschaltet sind. Über Kapazitäten 81 können somit Gegentaktstörungen gefiltert werden, so dass die Kapazitäten wie X-Kapazitäten wirken. Wird der Sternpunkt 83 des gesteuerten Filters 72 über den Schalter 79 mit der Erde 20 verbunden, so können die Kapazitäten 81 auch Gleichtaktstörungen erden, so dass sie wie XY-Kapazitäten wirken.

Der Schalter 79 wird durch die Messvorrichtung 74 über ein Relais 77 gesteuert, die wie in den vorangehenden Ausführungsbeispielen einen Fehlerstrom durch die Kapazitäten 81 zur Erde 20 erfasst und prüft, ob dieser zu hoch ist. Ist dies der Fall kann die Messvorrichtung 74 das gesteuerte Filter 72 von der Erde 20 trennen. Der Schalter 79 ist als Schließer ausgeführt. Auf diese Weise ist sichergestellt, dass das Relais 77 bei einem Ausfall des Stroms zur Steuerung des Relais 77 das gesteuerte Filter 72 vom Netz getrennt bleibt.

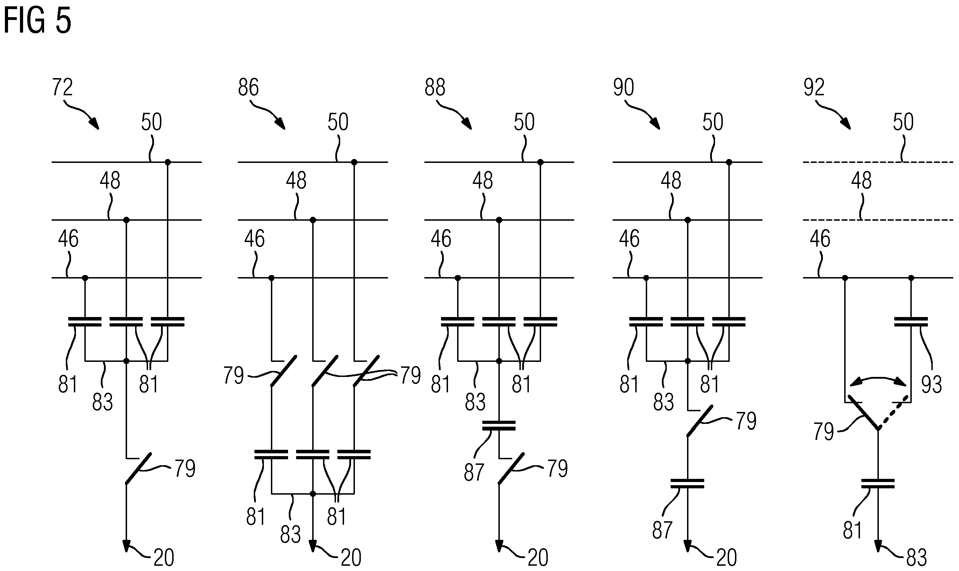

In FIG 5 sind verschiedene Topologien für das gesteuerte Filter 72 aus FIG 4 dargestellt. In FIG 5 werden zu FIG 4 gleiche Elemente mit gleichen Bezugszeichen versehen und nicht noch einmal erläutert.

In der ersten Topologie 72, die bereits in FIG 4 gezeigt ist, kann der Sternpunkt 83 durch den Schalter 79 von der Erde 20 getrennt werden. Demgegenüber kann in einer alternativen Topologie 86, jede Kapazitäten 81 einzeln durch einen Schalter 79 von der Erde 20 getrennt werden, so dass in Phasen 46, 48, 50, die nicht von einem Fehlerstrom betroffen sind, weiterhin Erdableitströme mit Frequenzen im Bereich des Leistungsstromes gefiltert werden können.

In einer dritten Topologie 88 kann der Sternpunkt 83 über eine Y-Kapazität 87 geerdet werden. Dabei kann der Schalter 79 zum Trennen des gesteuerten Filters von der Erde 20, von der Erde 20 aus gesehen, vor der Y- Kapazität 87 angeordnet sein kann. In einer vierten Topologie 90, die wie die dritte Topologie 88 aufgebaut ist, kann der Schalter 79 von der Erde 20 aus gesehen nach der Y- Kapazität 87 angeordnet sein.

In einer fünften Topologie 92, die hier lediglich für die erste Phase 46 dargestellt ist kann im Fehlerfall eine zusätzliche XY-Kapazität 93 über den Schalter 79 zur XY-Kapazität 81 zugeschaltet werden. Diese zusätzliche XY-Kapazität 93 könnte sehr klein dimensioniert werden, dass sie im Fehlerfall die Grenzfrequenz des gesteuerten Filters 72 erhöht und somit den Fehlerstrom 28 im Fehlerfall reduziert. In den Ausführungsbeispielen wird eine Kapazität zum Erden von Erdableitströmen in einem Stromversorgungsnetz im Fehlerfall derart angepasst, dass die Filterung von Erdableitströmen, die eine Frequenz des Leistungsstromes des Stromversorgungsnetzes aufweisen, ausgeschlossen ist.

### Bezugszeichenliste

- 2: Netzwerk
- 4: elektrischer Verbraucher
- 6: elektrische Energiequelle
- 8: Leistungsstrom
- 10: erste Phase
- 12: zweite Phase
- 14: Gleichrichter
- 16: Erdkapazität
- 18: Erdableitstrom
- 20: Erde
- 22: Netzfilterkapazität
- 28: Fehlerstrom
- 30: Drossel
- 32: Netzwerk
- 34: Messvorrichtung
- 36: einstellbare Netzfilterkapazität
- 38: Datenleitung
- 40: Stellvorrichtung
- 42: erstes Stellsignal
- 43: zweites Stellsignal
- 44: Netzfilterschaltung
- 45: Netzwerk
- 46: erste Phase
- 48: zweite Phase
- 50: dritte Phase
- 54: elektrische Energiequelle
- 56: dreiphasige Last
- 58: Messvorrichtung
- 59: Netzschütz
- 60: Schalter erste Phase
- 62: Schalter zweite Phase
- 64: Schalter dritte Phase
- 66: Ansteuersignal
- 68: Relais
- 70: Netzwerk
- 72: gesteuerte Netzfilterschaltung
- 74: Messvorrichtung
- 76: Last
- 77: Stelleinrichtung
- 79: Schalter der gesteuerten Netzfilterschaltung
- 80: elektrische Energiequelle
- 81: Kapazitäten der gesteuerten Netzfilterschaltung
- 82: ungesteuerte Netzfilterschaltung
- 83: Sternpunkt der Kapazitäten der gesteuerten Netzfilterschaltung
- 86: zweite Topologie für gesteuerte Netzfilterschaltung
- 87: Y-Kapazität der gesteuerten Netzfilterschaltung
- 88: dritte Topologie für gesteuerte Netzfilterschaltung
- 90: vierte Topologie für gesteuerte Netzfilterschaltung
- 92: fünfte Topologie für gesteuerte Netzfilterschaltung
- 93: zusätzliche XY-Kapazität der gesteuerten Netzfilterschaltung

## Patentansprüche

1. Vorrichtung zum Schutz eines Filters (36, 44, 72),
- wobei das Filter (36, 44, 72) zwischen einer elektrischen Energiequelle (6, 54, 80) und einer Störquelle (14) verschaltet ist, und dazu ausgebildet ist, eine Netzspannung der elektrischen Energiequelle (6, 54, 80) an die Störquelle (14) weiterzuleiten und Störtransiente (18) aus der Erde (20) in den Eingang der die Störtransiente (18) erzeugenden Störquelle (14) zurückzuführen, und
- wobei die Störquelle (14) ein Gleichrichter zum Wandeln der Netzspannung in eine Lastspannung für einen elektrischen Verbraucher (4, 56, 76) ist,
wobei die Vorrichtung zum Schutz des Filters umfasst:
- eine Messeinrichtung (34, 58, 74) zum Ermitteln eines durch das Filter (36, 44, 72) fließenden Fehlerstromes (28), und
- eine Stelleinrichtung (40, 59, 77), die ausgebildet ist, eine Grenzfrequenz des Filters (36, 44, 72) derart zu verändern, dass der Fehlerstrom (28) durch das Filter (36, 44, 72) unter einen vorbestimmten Pegel gedämpft wird, und die Störquelle (14) in einen passiven Betriebsmodus zu überführen, in dem die Netzspannung der elektrischen Energiequelle (6) mit Dioden gleichgerichtet wird, wenn die Messeinrichtung (34, 58, 74) den Fehlerstrom (28) erfasst,
- wobei das Filter (36, 44, 72) wenigstens eine Kapazität (36, 81) aufweist und die Stelleinrichtung (40, 59, 77) zum Verändern der Grenzfrequenz des Filters (36, 44, 72) ausgebildet ist, die Kapazität (36, 81) zu verändern.

2. Vorrichtung nach Anspruch 1, wobei die elektrische Energiequelle (6, 54, 80) zur mehrphasigen elektrischen Energieabgabe an die Störquelle (14) und das Filter (36, 44, 72) zum Zurückführen von Störtransienten (18) aus der Erde (20) in den Eingang der Störquelle (14) in allen Phasen vorgesehen ist, wobei die Messeinrichtung (34, 58, 74) zum Erfassen des Fehlerstromes (28) ausgebildet ist, eine unsymmetrische elektrische Energieabgabe aus der elektrischen Energiequelle (6, 54, 80) zu erfassen.

3. Vorrichtung nach Anspruch 2, wobei die Messeinrichtung (34, 58, 74) zum Erfassen der unsymmetrischen elektrischen Energieabgabe basierend auf
- den Phasenströmen der elektrischen Energiequelle (6, 54, 80), oder
- den Phasenspannungen der elektrischen Energiequelle (6, 54, 80), oder
- den Gleichtaktstörungen in den einzelnen Phasen (10, 12, 46, 48, 50) zwischen der elektrischen Energiequelle (6, 54, 80) und der Störquelle (14), oder
- einem Spannungsabfall von einem künstlichen Sternpunkt (83) im Filter (36, 44, 72) zur Erde (20) vorgesehen ist.

4. Vorrichtung nach einem der Ansprüche 1 bis 3, wobei das Filter (36, 44, 72) eine erste Kapazität (36, 81) und eine zweite Kapazität umfasst, die parallel zur ersten Kapazität (36, 81) geschaltet ist, wobei die erste Kapazität (36, 81) ausgebildet ist, Störtransiente (18) mit der Frequenz des Fehlerstromes (28) und die zweite Kapazität ausgebildet ist, Störtransiente (18) mit einer von der Frequenz des Fehlerstromes (28) verschiedenen Frequenz zu leiten.

5. Vorrichtung nach Anspruch 4, wobei die Stelleinrichtung (40, 59, 77) ausgebildet ist, die erste Kapazität (36, 81) vom Filter (36, 44, 72) elektrisch zu trennen, wenn die Messeinrichtung (34, 58, 74) den Fehlerstrom (28) erfasst.

6. Vorrichtung nach einem der Ansprüche 1 bis 5, wobei der Fehlerstrom (28) eine Frequenz eines von der elektrischen Energiequelle (6, 54, 80) abgegebenen Stromes (8) aufweist.

7. Vorrichtung nach einem der Ansprüche 1 bis 6, wobei die Stelleinrichtung (40, 59, 77) zum Reduzieren einer elektrischen Leistungsabgabe des Gleichrichters (14) vorgesehen ist, wenn die Messvorrichtung (34, 58, 4) den Fehlerstrom (28) ermittelt.

8. Verfahren zum Schutz eines Filters (36, 44, 77) mit einer Vorrichtung nach einem der Ansprüche 1 bis 7,
**gekennzeichnet durch**
- Erfassen eines durch den Filter (36, 44, 72) fließenden Fehlerstromes (28), und
- Verändern einer Grenzfrequenz des Filters (36, 44, 72) derart, dass der Fehlerstrom (28) durch den Filter (36, 44, 72) unter ein vorbestimmtes Pegel gedämpft wird, wenn der Fehlerstrom (28) erfasst wird.

## Claims

1. Device for protecting a filter (36, 44, 72),
- wherein the filter (36, 44, 72) is connected up between an electrical energy source (6, 54, 80) and a source of interference (14), and is designed to pass a line voltage from the electrical energy source (6, 54, 80) to the source of interference (14) and to feed back interference transients (18) from ground (20) to the input of the source of interference (14) generating the interference transients (18), and
- wherein the source of interference (14) is a rectifier for converting the line voltage into a load voltage for an electrical consumer (4, 56, 76),
wherein the device for protecting the filter comprises:
- a measuring device (34, 58, 74) for determining a leakage current (28) flowing through the filter (36, 44, 72), and
- a final control element (40, 59, 77) which is designed to modify a limit frequency of the filter (36, 44, 72) such that the leakage current (28) through the filter (36, 44, 72) is damped to below a predefined level, and to transfer the source of interference (14) into a passive operating mode in which the line voltage of the electrical energy source (6) is rectified with diodes if the measuring device (34, 58, 74) detects the leakage current (28),
- wherein the filter (36, 44, 72) has at least one capacitor (36, 81) and the final control element (40, 59, 77) to modify the limit frequency of the filter (36, 44, 72) is designed to modify the capacitor (36, 81).

2. Device according to claim 1, wherein the electrical energy source (6, 54, 80) is provided for outputting multiphase electrical energy to the source of interference (14) and the filter (36, 44, 72) is provided for feeding back interference transients (18) from ground (20) to the input of the source of interference (14) in all phases, the measuring device (34, 58, 74) for detecting the leakage current (28) being designed to detect an asymmetrical electrical energy output from the electrical energy source (6, 54, 80).

3. Device according to claim 2, wherein the measuring device (34, 58, 74) for detecting the asymmetrical electrical energy output is based on
- the phase currents of the electrical energy source (6, 54, 80), or
- the phase voltages of the electrical energy source (6, 54, 80), or
- the common-mode interferences in the individual phases (10, 12, 46, 48, 50) between the electrical energy source (6, 54, 80) and the source of interference (14), or
- a voltage drop from an artificial neutral point (83) in the filter (36, 44, 72) to ground (20).

4. Device according to one of claims 1 to 3, wherein the filter (36, 44, 72) comprises a first capacitor (36, 81) and a second capacitor, which is connected in parallel to the first capacitor (36, 81), wherein the first capacitor (36, 81) is designed to conduct interference transients (18) with the frequency of the leakage current (28) and the second capacitor is designed to conduct interference transients (18) with a frequency different from the frequency of the leakage current (28).

5. Device according to claim 4, wherein the final control element (40, 59, 77) is designed to electrically isolate the first capacitor (36, 81) from the filter (36, 44, 72) if the measuring device (34, 58, 74) detects the leakage current (28).

6. Device according to one of claims 1 to 5, wherein the leakage current (28) has a frequency of a current (8) emitted by the electrical energy source (6, 54, 80).

7. Device according to one of claims 1 to 6, wherein the final control element (40, 59, 77) is provided to reduce an electrical power output of the rectifier (14) if the measuring device (34, 58, 4) determines the leakage current (28).

8. Method for protecting a filter (36, 44, 77), having a device according to one of claims 1 to 7, **characterised by**:
- detecting a leakage current (28) flowing through the filter (36, 44, 72), and
- modifying a limit frequency of the filter (36, 44, 72) such that the leakage current (28) through the filter (36, 44, 72) is damped to below a predefined level if the leakage current (28) is detected.

## Revendications

1. Installation de protection d'un filtre (36, 44, 72),
- dans laquelle le filtre (36, 44, 72) est monté entre une source (6, 54, 80) d'énergie électrique et une source (14) perturbatrice et est constitué pour acheminer une tension de réseau de la source (6, 54, 80) d'énergie électrique à la source (14) perturbatrice et pour retourner des transitoires (18) perturbateurs de la terre (20) à l'entrée de la source (14) perturbatrice produisant les transitoires (18) perturbateurs et
- dans laquelle la source (14) perturbatrice est un redresseur de transformation de la tension de réseau en une tension de charge pour un consommateur (4, 56, 76) électrique,
l'installation de protection du filtre comprenant :
- un dispositif (34, 58, 74) de mesure, pour déterminer un courant (28) de défaut passant dans le filtre (36, 44, 72) et
- un dispositif (40, 59, 77) de réglage, constitué pour faire varier une fréquence limite du filtre (36, 44, 72), de manière à amortir, sous un niveau déterminé à l'avance, le courant (28) de défaut passant dans le filtre (36, 44, 72) et à faire passer la source (14) perturbatrice à un mode de fonctionnement passif, dans lequel la tension de réseau de la source (6) d'énergie électrique est redressée par des diodes, si le dispositif (34, 58, 74) de mesure détecte le courant (28) de défaut,
- dans laquelle le filtre (36, 44, 72) a au moins une capacité (36, 81) et le dispositif (40, 59, 77) de réglage est, pour faire varier la fréquence limite du filtre (36, 44, 72), constitué pour faire varier la capacité (36, 81).

2. Installation suivant la revendication 1, dans laquelle la source (6, 54, 80) d'énergie électrique est prévue, dans toutes les phases, pour distribuer de l'énergie électrique polyphasée à la source (14) perturbatrice et le filtre (36, 44, 72), pour retourner des transitoires (18) perturbateurs de la terre (20) à l'entrée de la source (14) perturbatrice, le dispositif (34, 58, 74) de mesure de détection du courant (28) de défaut étant constitué pour détecter une distribution d'énergie électrique dissymétrique par la source (6, 54, 80) d'énergie électrique.

3. Installation suivant la revendication 2, dans laquelle le dispositif (34, 58, 74) de mesure est prévu pour détecter la distribution d'énergie électrique dissymétrique sur la base
- des courants de phase de la source (6, 54, 80) d'énergie électrique ou
- des tensions de phase de la source (6, 54, 80) d'énergie ou
- des perturbations en mode commun dans les diverses phases (10, 12, 46, 48, 50) entre la source (6, 54, 80) d'énergie électrique et la source (14) perturbatrice ou
- d'une chute de tension d'un point (83) neutre artificiel du filtre (36, 44, 72) à la terre (20).

4. Installation suivant l'une des revendications 1 à 3, dans laquelle le filtre (36, 44, 72) comprend une première capacité (36, 81) et une deuxième capacité, qui est montée en parallèle à la première capacité (36, 81), la première capacité (36, 81) étant constituée pour conduire des transitoires (18) perturbateurs, ayant la fréquence du courant (28) de défaut, et la deuxième capacité pour conduire des transitoires (18) perturbateurs, ayant une fréquence différente de la fréquence du courant (28) de défaut.

5. Installation suivant la revendication 4, dans laquelle le dispositif (40, 59, 77) de réglage est constitué pour séparer électriquement la première capacité (36, 81) du filtre (36, 44, 72), si le dispositif (34, 58, 74) de mesure détecte un courant (28) de défaut.

6. Installation suivant l'une des revendications 1 à 5, dans laquelle le courant (28) de défaut a une fréquence d'un courant (8) distribué par la source (6, 54, 80) d'énergie électrique.

7. Installation suivant l'une des revendications 1 à 6, dans laquelle le dispositif (40, 59, 77) de réglage est prévu pour réduire une distribution de puissance électrique du redresseur (14), si le dispositif (34, 58, 4) de mesure détermine le courant (28) de défaut.

8. Procédé de protection d'un filtre (36, 44, 77) par une installation suivant l'une des revendications 1 à 7, **caractérisé par**
- la détection d'un courant (28) de défaut passant dans le filtre (36, 44, 72), et
- la variation d'une fréquence limite du filtre (36, 44, 72), de manière à amortir, sous un niveau déterminé à l'avance, le courant (28) de défaut dans le filtre (36, 44, 72), si l'on détecte le courant (28) de défaut.
